# EUROPEAN PATENT APPLICATION

(11) **EP 0 791 937 A2**
(43) Date of publication of application: **27.08.1997**
(21) Application number: 97301168.7
(22) Date of filing: 21.02.1997
(51) Int. Cl.: H01B 12/00

(54) **Conductor using superconducting material and electric apparatus using the same**

(30) Priority: 23.02.1996 JP 36677/96
(71) Applicant: HITACHI CABLE, LTD., Chiyoda-ku Tokyo 100 (JP)
(72) Inventor: Sato, Junichi, Hitachinaka-shi, Ibaraki-ken (JP); Sasaoka, Takaaki, Tsuchiura-shi, Ibaraki-ken (JP); Kuma, Syoji, Naka-gun, Ibaraki-ken (JP)
(74) Representative: Jackson, Peter Arthur

(57) **Abstract**

A conductor using a superconducting oxide material comprises a conductive body comprising at least one superconducting oxide. The conductive body presents a specific resistance of between 10⁻¹³ Ω·m and 10⁻⁷ Ω·m in its use. It is preferably used at a temperature of between 20 K and Tc+3 K, where Tc is a critical temperature where the specific resistance becomes below 10⁻⁷ Ω·m. The voltage/current ratio of the conductive body is preferably lower than 20 to stably maintain the low resistance state. A conductive tape produced by coating a bundle of 61 superconducting oxide wires having a composition of Bi_{1.84}Pb_{0.34}Sr_{1.9}Ca_{2.2}Cu_{3.1}Oₓ with an Ag layer, and a complex conductor using the tape are disclosed.

## Description

This invention relates to a conductor using a superconducting oxide material and an electric apparatus using the same, and more particularly to, a conductor which utilizes the superconducting oxide as a extremely low resistance conductive body.

Nowadays, conducting materials of a relatively low resistance, such as copper, aluminum etc., are generally used as conductors for current flow in electric apparatuses. These conducting materials present a specific resistance of approximately 2x10⁻⁸ Ω·m at room temperature, and that of approximately 2x10⁻⁹ Ω·m at around 77K, which is the boiling temperature of liquid nitrogen.

According to the conventional conductors and electric apparatus using the same, an electric resistance occurs in accordance with the length and cross-sectional area of the conductors, which cause the conductors and electric apparatus using the same to generate heat. Consequently, such conductors and electric apparatus using the same that need to be cooled at a low temperature do not tend to be cost-effective.

A current-carrying capacity of these conventional conductors is limited, depending on its cross-sectional area or volume. When a higher current-carrying capacity is desired, the larger cross-sectional area or volume of the conductor is necessary. As a result, the volume of the conductor and the electric apparatus using the same becomes bigger.

On the other hand, in order to obtain a low resistance property, the use of an oxygen free copper at relatively lower temperature has been proposed, for example. The specific resistance of the oxygen free copper decreases in accordance with its temperature. Although the decreasing rate of specific resistance depends on the purity of the oxygen free copper, it is known that, under its cryogenic operation, the larger the residual resistance ratio (hereinafter referred to as "RRR", where RRR is defined by the equation RRR = ρ_{300K}/ρ_{4.2K}) is, the larger the decreasing rate of specific resistance is (see "Superconductor/Cryogenics Handbook", edited by Cryogenics Society of Japan, Ohm Sha, p.91),

TABLE 1 shows the variations of specific resistance of the oxygen free coppers having various RRRs at various temperatures.

**TABLE 1**

| RRR OF OXYGEN FREE COPPER | SPECIFIC RESISTANCE [Ω·m] | | | |
|---|---|---|---|---|
| | 4.2K | 20K | 77K | 300K |
| 30 | 5x10⁻¹⁰ | 5.5x10⁻¹⁰ | 2x10⁻⁹ | 1.7x10⁻⁸ |
| 300 | 5x10⁻¹¹ | 6x10⁻¹¹ | | |
| 3000 | 5x10⁻¹² | 1.1x10⁻¹¹ | | |
| 30000 | 5x10⁻¹³ | 7x10⁻¹² | | |

As shown in TABLE 1, the specific resistances of the oxygen free coppers vary from 5x10⁻¹³ Ω·M to 5x10⁻¹⁰ Ω·m at 4.2K, and from 7x10⁻¹² Ω·m to 5.5x10⁻¹⁰ Ω·m at 20K, in accordance with the variation of RRR, respectively. In both cases, the specific resistances are obtained within the temperature range of liquid helium. By contrast, at 77K (the boiling temperature of liquid nitrogen) and 300K (room temperature), the specific resistances are 2x10⁻⁹ Ω·m and 1.7x10⁻⁸ Ω·m, respectively, and no variations thereof are observed (see "Cryogenics", Experimental Physics Course 15, Kyoritsu Shuppan, p287).

In the conventional conductor like oxygen free copper, however, there is a disadvantage in that it is not cost-effective, because the material of higher purity is required to obtain higher RRR (i.e., lower resistance). Another disadvantage is that as the purity of the material becomes high, the mechanical properties, such as Young's modulus, proof stress, etc., and the thermal properties like thermal conductivity, etc., become unadjustable.

### SUMMARY OF THE INVENTION

Accordingly, it is an object of the invention to provide a conductor using a superconducting oxide material and an electric apparatus using the same by which an extremely low specific resistance is obtained at lower cost.

It is a further object of the invention to provide a conductor using a superconducting oxide material and an electric apparatus using the same in which a relatively free adjustment of mechanical and thermal properties are possible.

It is a still further object of the invention to provide a conductor using a superconducting oxide material and an electric apparatus using the same, the specific resistance of which is substantially equal to or lower than that of conventional conductor at relatively higher temperature.

According to the first feature of the invention, a conductor using a superconducting oxide material, comprises:
a conductive body comprising at least one superconducting oxide; wherein the conductive body presents a specific resistance of between 10⁻¹³ Ω·m and 10⁻⁷ Ω·m in its use.

According to the second feature of the invention, an electric apparatus including a conductive body, comprising: a conductive body comprising at least one superconducting cxide; wherein the conductive body presents a specific resistance of between 10⁻¹³ Ω·m and 10⁻⁷ Ω·m in its use.

In the invention, the specific resistance of the conductive body is necessarily between 10⁻¹³ Ω·m and 10⁻⁷ Ω·m. If it is higher than 10⁻⁷ Ω·m, it may not be referred to "low resistance". If it is lower than 10⁻¹³ Ω·m, the conductor is in the superconductive state by definition.

The conductor and the electric apparatus using the same in the invention is preferably used at a temperature of between 20 K and Tc+3 K, where Tc is a critical temperature where the specific resistance becomes below 10⁻⁷ Ω·m. If the temperature is higher than Tc+3 K, an extremely low resistance region after the break of superconductive state does not exist. On the other hand, if it is lower than 20 K, extremely low specific resistances are also obtained by certain conventional conductors like oxygen free copper having relatively high RRR. For example, the specific resistances of the oxygen free coppers are between 5x10⁻¹³ Ω·m and 5x10⁻¹⁰ Ω·m at 4.2 K, and between 7x10⁻¹² Ω·m and 5.5x10⁻¹⁰ Ω·m at 20 K.

Moreover, the voltage/current ratio of the conductive body, (i.e., the gradient of generated voltage to current, hereinafter referred to as "n-value") is preferably lower than 20. If the n-value is larger than 20, the superconducting oxide may be quenched, which may result in the difficulty in stably maintaining the low resistance state.

The invention will be explained in more detailed in conjunction with the appended drawings, wherein:
FIG. 1 is a graph showing an example of voltage relative to current characteristics of a conducting tape according to the invention, and
FIG. 2 is a perspective view showing a complex conductor as an example of an electric apparatus according to the invention.

The inventors have researched the relation between current and generated voltage in superconducting oxide materials at various temperatures, especially below Tc+3 K in detail. As a result, it is found that after an extremely low resistance is generated (i.e., after the superconductive state is broken), a certain region of extremely low resistance exists.

It is also found that the n-value of superconducting oxide in this region is much smaller than those of other superconducting materials, such as metals, metal alloys and intermetallic compounds. Superconducting oxides have a n-value of 20 or less, while superconducting metals, metal alloys and intermetallic compound. have a n-value of 20-50. According to the usual superconducting metals, metal alloys and intermetallic compounds, when a current over its critical current flows through the material, a voltage and a resistance are suddenly generated, which causes the material to be heated by Joule's heat. Then, the material is heated more due to the decrease of the critical current. Finally, by repeating this process, the material is quenched. According to superconducting oxides, this phenomenon is not observed. This means that a conductor having a predetermined specific resistance in accordance with a predetermined amount of current may be selected in user's discretion.

Due to the reason explained above, a current-carrying capacity of the superconducting oxides may be greatly increased by not defining the maximum current as the critical current where the specific resistance is 10⁻¹⁴ Ω·m or 10⁻¹³ Ω·m (i.e, critical current density), but using the superconducting oxide such that the specific resistance thereof is between 10⁻¹³ Ω·m (superconducting state) and 10⁻⁷ Ω·m (low resistance state). Preferably, the specific resistance may be between 10⁻¹³ Ω·m and 10⁻⁸ Ω·m, which is lower than that of oxygen free copper at room temperature (300K). And more preferably, it may be between 10⁻¹³ Ω·m and 10⁻⁹ Ω·m, which is lower than that of oxygen free copper at 77 K.

In the invention, superconducting oxide material used for a conducting body is not limited to a superconducting oxide of Bi-containing Cu system, but includes any other superconducting oxide materials by which a higher critical current density and a larger current in the low resistance state are obtained. The superconducting oxide materials may include materials of Pb-containing Bi system, such as Bi-2201, Bi-2212, and Bi-2223, not Pb-containing Bi system of same kinds, materials of single layer Tl system like (Tl,Pb)(Sr,Ba)₂Ca₂Cu₃Oₓ, and materials of Hg system, such as HgBa₂Ca₁Cu₂O_{y}, and HgBa₂Ca₂Cu₃O_{y}.

According to the invention, complex mechanical and thermal properties of the superconducting body used for a conductor may be selectively obtained by combining the superconducting body and other bodies of metals and/or ceramics in accordance with a law of complex.

It is apparently understood that, in the invention, not only the conductor and the electric apparatus using the same as a whole may be operated at a predetermined low temperature to realize the low resistance state, but also may a part of the conductor and the electric apparatus using the same be.

Now, examples of the conductor and the electric apparatus using the same in the invention will be explained below.

### EXAMPLE 1

Wires of superconducting oxide having a composition of Bi_{1.84}Pb_{0.34}Sr_{1.9}Ca_{2.2}Cu_{3.1}Oₓ are fabricated. Then, a conductive tape is produced by coating a bundle of 61 superconducting wide wires with an Ag layer.

The resulting conductive tape is 4.0 mm wide, 0.25 mm thick, and 1 m long. Its Ag ratio is 3, and a main phase of the superconducting oxide is Bi-2223 phase. The critical temperature Tc where the specific resistance becomes below 10⁻⁷ Ω·m is 107 K.

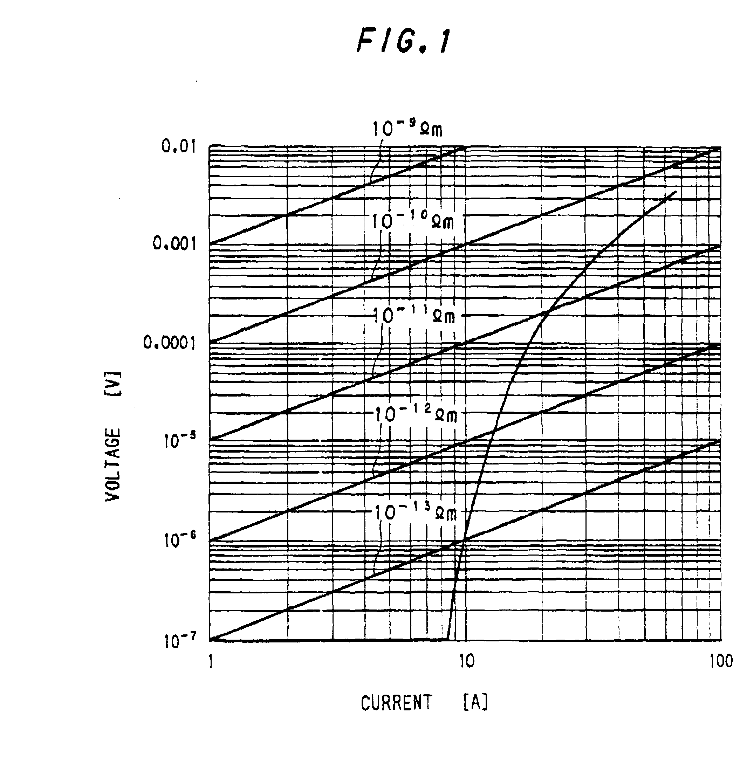

FIG. 1 shows voltage relative to current characteristics of the conductive tape at the liquid nitrogen temperature (77 K), which are measured by a four-terminal method.

As shown in FIG. 1, the current of 21 A is converted as the specific resistance of 10⁻¹¹ Ω·m, which is one two-hundredth (1/200) of that of oxygen free copper which is 2x10⁻⁹ Ω·m under the same temperature and the same current conditions. The n-value of the tape at that point is 3.8.

Moreover, the currents of 12 A and 10 A are converted as the specific resistances of 10⁻¹² Ω·m and 10⁻¹³ Ω·m, respectively, which are lower than those of oxygen free copper under the same temperature and current conditions. The n-values of the conductive tape at these points are 7.9 and 14.6, respectively. The method of fabricating the tape may include, but not be limited to, dipcoating method, doctor blade method, plasma spraying method , screen printing method, spray pyrolysis method, etc..

### EXAMPLE 2

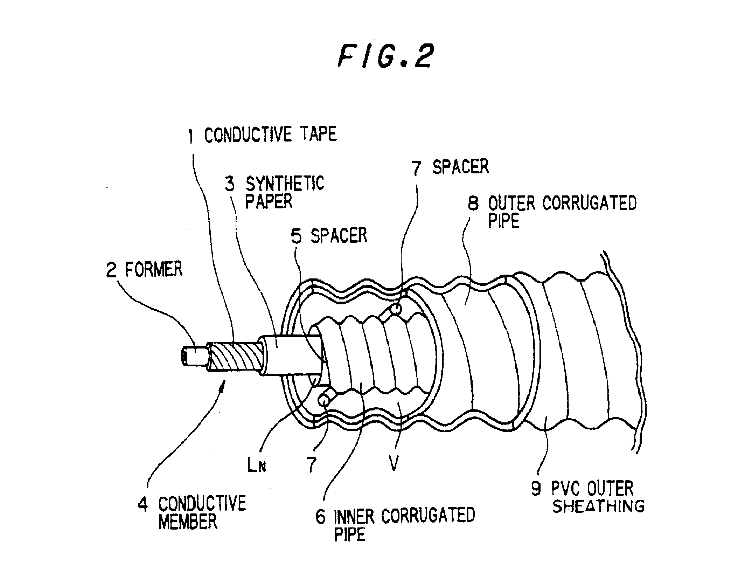

In FIG. 2, a complex conductor as an example of an electric apparatus using the conductive tape of EXAMPLE 1 according to the invention is shown. The complex conductor comprises ten conductive . tapes 1 of EXAMPLE 1 wound around a former of SUS304 with a pitch of 150 mn in a form of ten layers, a synthetic paper 3 wound around the eonductive tapes 1 to form a conductive member 4, an inner corrugated pipe 6 of copper for surrounding the conductive member 4 through a spacer 5, an outer corrugated pipe 8 of copper for surrounding the inner corrugated pipe 6 through a spacer 7, and a PVC outer sheathing 9 for covering the outer corrugated pipe 8.

In operation, liquid nitrogen L_{N} is circulated through a space between the conductive member 4 and the inner corrugated pipe 6. A vacuum space V between the inner corrugated pipe 6 and the outer corrugated pipe 8 functions as a heat insulating layer.

When a direct current of 2,100 A flows through the complex conductor at liquid nitrogen temperature (77 K), the specific resistance is converted as 10-¹¹ Ω·m and the cross-sectional area of the conductive member 4 is 1x10³ mm². Since the specific resistance of oxygen free copper under the same temperature and current conditions is to be 2x10⁻¹⁹ Ω·m, the oxygen free copper conductor must have a cross-sectional area of 2x10⁵ mm2 so as to obtain the same specific resistance under the same conditions, which is two hundred times as large as that of the conductive member 4 in the example.

Besides winding the tapes 1 around the former 2 in a plurality of layers to form the conductive member, other forms of wires, such as single-core wire, multiple-core wire, multiple-layer wire, twisted wires, stranded wires, and bulk form may be applicable to the example.

According to the invention, the electric apparatus includes electric devices, such as magnet, lead wire, bus bar, cable, current limiter, magnetic shield, and electric circuit having a fine wiring pattern, which may be used under an application of magnetic field.

## Claims

1. A conductor using a superconducting oxide material, comprising: a conductive body comprising at least one superconducting oxide; wherein said conductive body presents a specific resistance of between 10⁻¹³ Ω·m and 10⁻⁷ Ω·m in its use.

2. A conductor using a superconducting oxide material, according to claim 1, wherein:
said conductive body is used at a temperature of between 20 K and Tc+3 K;
wherein Tc is a critical temperature where said specific resistance becomes below 10⁻⁷ Ω·m.

3. A conductor using a superconducting oxide material, according to claim 1, wherein:
a voltage/current ratio of said conductive body is less than 20.

4. A conductor using a superconducting oxide material, according to claim 1, wherein:
said at least one superconducting oxide is a superconducting oxide in the Bi-containing Cu system.

5. A conductor using a superconducting oxide material, according to claim 1, wherein:
said conductive body is a complex body of said at least superconducting oxide and at least one metallic material and/or at least ceramic material

6. An electric apparatus including a conductive body, comprising:
a conductive body comprising at least one superconducting oxide;
wherein said conductive body presents a specific resistance of between 10⁻¹³ Ω·m and 10⁻⁷ Ω·m in its use.

7. An electric apparatus including a conductive body, according to claim 1, wherein:
said electric apparatus includes electric devices, such as magnet, lead wire, bus bar, cable, current limiter, magnetic shield, and electric circuit having a fine wiring pattern.

8. A electric conducting system having a relatively lower specific resistance at relatively lower temperature, comprising:
means for conducting current with a specific resistance of between 10⁻¹³ Ω·m and 10⁻⁷ Ω·m, and
means for cooling the current conducting means at a temperature of between 20 K and Tc+3 K;
wherein Tc is a critical temperature where said specific resistance becomes below 10⁻⁷ Ω·m.
